Europäisches Patentamt

European Patent Office

Office européen des brevets

(19)

(11) Veröffentlichungsnummer: **0 511 492 B1**

(12) **EUROPÄISCHE PATENTSCHRIFT**

(45) Veröffentlichungstag der Patentschrift: **02.11.94**

(51) Int. Cl.5: **C23C 16/50**, H01J 37/32

(21) Anmeldenummer: **92105098.5**

(22) Anmeldetag: **25.03.92**

(54) **Verfahren und Vorrichtung zur Behandlung oder Beschichtung von Substraten.**

(30) Priorität: **30.04.91 DE 4114108**

(43) Veröffentlichungstag der Anmeldung:
**04.11.92 Patentblatt 92/45**

(45) Bekanntmachung des Hinweises auf die
Patenterteilung:
**02.11.94 Patentblatt 94/44**

(84) Benannte Vertragsstaaten:
**BE CH DE FR GB IT LI NL**

(56) Entgegenhaltungen:
**EP-A- 0 420 117**
**FR-A- 2 636 078**
**US-A- 4 922 853**

**PATENT ABSTRACTS OF JAPAN, vol. 12, no. 191 (C-501), 3. Juni 1988; & JP-A-62 294 181**

**PATENT ABSTRACTS OF JAPAN, vol. 11, no. 290 (C-447), 18. September 1987; & JP-A-62 083 471**

**PATENT ABSTRACTS OF JAPAN, vol. 13, no. 568 (E-861), 15. Dezember 1989; & JP-A-12 36 629**

(73) Patentinhaber: **Schott Glaswerke**
**Hattenbergstrasse 10**
**D-55122 Mainz (DE)**

(84) Benannte Vertragsstaaten:
**BE CH DE FR IT LI NL**

(73) Patentinhaber: **Carl-Zeiss-Stiftung trading as SCHOTT GLASWERKE**
**Hattenbergstrasse 10**
**D-55122 Mainz (DE)**

(84) Benannte Vertragsstaaten:
**GB**

(72) Erfinder: **Otto, Jürgen**
**Draiser Strasse 110**
**W-6500 Mainz (DE)**

(74) Vertreter: **Dr. Fuchs, Dr. Luderschmidt Dr. Mehler, Dipl.-Ing. Weiss Patentanwälte**
**Postfach 46 60**
**D-65036 Wiesbaden (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf ein Verfahren zur Behandlung oder Beschichtung von Substraten, bei dem ein zur Abscheidung befähigtes Reaktionsgas über die zu beschichtende Fläche strömt und das Reaktionsgas mittels in einem Hohlleiter erzeugter Mikrowellen zu einem streifenförmigen Plasma angeregt wird. Die Erfindung betrifft auch eine Vorrichtung zur Durchführung des Verfahrens, wobei die Vorrichtung einen Reaktionsraum zur Aufnahme des zu behandelnden oder zu beschichtenden Substrates, einen Gaseinlaß für die Zuführung von Reaktionsgas in den Reaktionsraum und einen dem Reaktionsraum benachbarten Hohlleiter aufweist, in dem Mikrowellen der Wellenlänge $\lambda_h$ angeregt sind.

Zur Vergütung von Oberflächen verschiedener Materialien werden vielfach Plasmen verwendet, die durch höchst,-hoch- oder niederfrequente, sowie Gleichstromentladungen erzeugt werden. Anwendungsbeispiele sind die Bedruckbarmachung von Kunststoffoberflächen, daß heißt, die gezielte Veränderung des Benetzungsverhaltens von Flüssigkeiten oder die Beschichtung mit harten, kratzfesten Schichten oder Schichten, die die optischen und elektrischen Eigenschaften des Substrates günstig verändern (Interferenzschichtsysteme, Farbschichten, elektrisch leitende Schichten). Für viele Anwendungen ist eine hochgradige Gleichmäßigkeit der Behandlung oder Beschichtung in ihren verschiedenen Eigenschaften wie Schichtdicke, Porosität, Brechzahl und Leitfähigkeit wesentlich. Dies setzt im allgemeinen ein gleichmäßig über die ganze Fläche einwirkendes Plasma voraus.

Aus der DE-OS 3 830 249 ist ein Plasma - CVD - Verfahren zum Beschichten großflächiger, planarer Substrate bekannt, bei dem die Plasmaelektroden in einem Raster über oder unter den zu beschichtenden Flächen angeordnet werden, wobei der Abstand zwischen zwei benachbarten Plasmaelektroden so bemessen ist, daß ihre Plasmasäulen einander überlappen. Der Nachteil dieser Anordnung besteht darin, daß die von den Antennen abgegebenen Mikrowellenleistungsbeiträge sich nicht zu einem völlig gleichmäßigen Leistungseintrag in das Plasma überlagern. Außerdem können Interferenzeffekte der von den Antennen abgestrahlten Wellen auftreten, die ebenfalls die Gleichmäßigkeit stören.

Aus der DE-PS 3 147 986 ist eine Vorrichtung zur Erzeugung eines Mikrowellenplasmas für die Behandlung von Substraten bekannt, bei der eine Wellenleiterstruktur eingesetzt wird, die als "slow wave structure" bezeichnet wird. Auch diese Anordnung führt aufgrund des längs der Wellenleiterstruktur abnehmenden Energieeintrages in das Plasma zu einem inhomogenen Streifenplasma.

Aus M. Geisler, J. Kieser, E. Räuchle, R. Wilhelm, Journal fo Vacuum Sience and Technology A8, 908 (1990) "Elongated microwave electron cyclotron resonanz heating plasma source" ist eine streifenförmige Anordnung von Permanentmagneten und eine Mikrowelleneinkopplung mittles langgestreckter Hornstrahler zur Erzeugung eines streifenförmigen Plasmas bekannt.

Während die Relativbewegung von Substrat und streifenförmigem Plasma eine gute homogenisierende Behandlung und Beschichtung in Bewegungsrichtung ergibt, erscheint bei allen Varianten die Homogenität des Plasmas in Streifenrichtung unzureichend. Das eindimensionale Raster der Slow Wave Struktur führt auch bei versetzter Anordnung zweier solcher Antennen nicht zu einem vollständig gleichmäßigen Leistungseintrag in das Plasma.

Der Nachteil der ECR-Anordnung besteht neben den selben Bedenken wie bei der Slow-Wave-Struktur zusätzlich in dem benötigten niedrigen Prozessdruck. Will man nämlich hohe Beschichtungsraten erzielen, was im allgemeinen der Fall ist, so muß man Pumpen mit großem Saugvermögen verwenden, um hohe Massenflüsse bei niedrigem Prozessdruck abpumpen zu können. Dies stellt einen unerwünscht hohen, apparativen Aufwand dar. Auch steigen die Anforderungen an die Dichtigkeit etwa verwendeter Substratschleusen. Ein weiterer Nachteil besteht darin, daß große Vorlaufzeiten erforderlich sind, um den notwendigen Betriebsdruck einzustellen.

Aus der DE-OS 3 926 023 ist ein CVD-Beschichtungsverfahren zur Herstellung von Schichten und eine Vorrichtung zur Durchführung des Verfahrens bekannt, bei dem über dem Reaktionsraum, in dem sich das zu beschichtende Substrat befindet, ein Vorraum in Gestalt eines metallischen Rohres mit einer spaltförmigen Öffnung angeordnet ist. In diesem Vorraum werden Mikrowellen erzeugt, die im Vorraum ein Plasma anregen. Die Anregung des in den Reaktionsraum eingeleiteten Reaktionsgases erfolgt dann durch angeregte Spezies, die aus dem Plasma in den Reaktionsraum strömen. Das Plasma befindet sich somit überwiegend im Vorraum und nicht im Reaktionsraum. Für die Beschichtung großflächiger Substrate wird das Substrat senkrecht zur schlitzförmigen Öffnung des Vorraumes bewegt. Der Nachteil dieses Verfahrens besteht darin, daß aufgrund der indirekten Anregung nur geringe Beschichtungs-und Reaktionsraten erzielbar sind. Dieses Verfahren ist weniger gut geeignet, um z.B. voll oxidierte und dichte Schichten mit geringer Porosität herzustellen.

Aufgabe der vorliegenden Erfindung ist daher ein Verfahren und eine Vorrichtung, mit dem großflächige Substrate wirtschaftlicher und insbesondere in kürzerer Zeit mit Schichten versehen werden können, wobei

EP 0 511 492 B1

die Schichten sowohl dichter, als auch homogener sein sollen, als die Schichten, die mit Verfahren gemäß dem Stand der Technik erzielbar sind.

Diese Aufgabe wird mit einem Verfahren gemäß den Merkmalen des Patentanspruchs 1 und mit einer Vorrichtung gemäß den Merkmalen des Patentanspruchs 11 gelöst. Vorteilhafte Ausgestaltungen sind Gegenstand der Unteransprüche.

Es hat sich gezeigt, daß die auf ein Substrat aufgebrachte Schicht weitaus homogener ist als bekannte Schichten, wenn zur Erzeugung eines streifenförmigen Plasmas in einem Hohlleiter zwei senkrecht zueinander polarisierte, stehende Wellen angeregt werden, die um eine viertel Wellenlänge relativ zueinander verschoben sind und die Ankopplung der Mikrowellen an das Plasma über einen in einer der Kanten des vorzugsweise quadratischen Hohlleiters angebrachten Längsschlitz (Koppelschlitz) erfolgt. Die Einspeisung der Mikrowellen erfolgt jeweils an den Enden des Hohlleiters.

Die Verwendung zweier stehender Wellen, die um eine viertel Wellenlänge relativ zueinander verschoben sind, bietet den Vorteil, daß die Knoten der einen stehenden Welle in die Bäuche der anderen stehenden Welle fallen, so daß der Leistungseintrag in das Plasma weitgehend vergleichmäßigt wird.

Die Verwendung von zwei polarisierten Wellen, deren Polarisationsrichtungen senkrecht zueinander stehen, hat den Vorteil, daß sich die beiden Wellen nicht gegenseitig beeinflussen und somit unabhängig voneinander sind. Für derartige linear polarisierte Wellen sind in der Kante des quadratischen Hohlleiters die gleichen Bedingungen vorzufinden, so daß es vorteilhaft ist, den Koppelschlitz in eine der Kanten des Hohlleiters zu legen.

Es hat sich herausgestellt, daß aufgrund der Mikrowelleneinspeisung an den beiden entgegengesetzten Enden des Hohlleiters der Leistungsabfall der einen Welle, der durch die Ankopplung an das Plasma in Richtung des Plasmastreifens - und somit auch in Richtung des Hohlleiters - entsteht, durch den in dieser Richtung auftretenden Leistungsanstieg, der von der anderen Seite eingekoppelten Wellen weitgehend kompensiert wird. Da der Leistungsabfall der beiden Wellen jeweils durch eine Exponentialfunktion beschrieben wird, die von der Dämpfung abhängt, wird zwar in der Mitte des Hohlleiters ein Leistungsminimum erreicht, das jedoch weitaus schwächer ausfällt, als bei den Verfahren nach dem Stand der Technik. Dies bedeutet, daß eine weitaus bessere Homogenität längs des Hohlleiters und damit auch eine weitgehend bessere Homogenität des auf das Substrat einwirkenden Plasmas erreicht wird.

Dadurch, daß der Innenraum des Hohlleiters vom Reaktionsraum abgetrennt ist, wird das Plasma im Gegensatz zur DE-OS 3 926 023 vollständig in den Reaktionsraum verlegt, so daß sich dieses unmittelbar über dem Substrat befindet. Dadurch wird eine hohe Beschichtungs-und Reaktionsrate erreicht. Weiterhin ist der direkte Kontakt des Substrates mit dem Plasma vorteilhaft, da sich die Schichten durch eine höhere Dichte und geringere Porosität auszeichnen.

Der Koppelschlitz in einer der Kanten des Hohlleiters unterbricht die Wandströme j des Hohlleiters. Diese variieren im Bereich der Kante in Längsrichtung X des Hohlleites gemäß folgender Gleichungen

$$j_1 = j_o * \sin(a * x) \text{ und}$$
$$j_2 = j_o * \cos(a * x),$$

wobei
$a = 2\pi/\lambda_h$ ist und $j_o$ den maximalen Wandstrom des Hohlleiters bezeichnet. $\lambda_h$ bezeichnet die Wellenlänge im Hohlleiter, wenn beide stehenden Wellen die gleiche Wellenlänge besitzen, und im Fall unterschiedlicher stehender Wellen, die aus beiden Wellenlängen gemittelte Wellenlänge. Die Dämpfung ist hierbei als vernachlässigbar klein angenommen.

Die Erfindung sieht zwei Ausführungsformen vor. Bei der ersten Ausführungsform werden zwei inkohärente Mikrowellensender verwendet, die zwei Wellen mit unterschiedlicher Wellenlänge $\lambda_{h1}$ und $\lambda_{h2}$ erzeugen. Vorzugsweise unterscheiden sich die beiden Wellenlängen $\lambda_{h1}$ und $\lambda_{h2}$ in weniger als einem Prozent voneinander. Dies bietet den Vorteil, daß die von den Wandströmen $j_1$ und $j_2$ abgestrahlten Einzelleistungen $P_1$ und $P_2$ sich zur Gesamtleistung $P$ additiv überlagern. Diese Gesamtleistung ist dann überall längs des Koppelschlitzes gleich, d.h. unabhängig von der Koordinate x:

$$P = P_1 + P_2 = P_o * \sin^2(ax) + P_o * \cos^2(ax) = P_o.$$

$P_o$ bedeutet hier die Maximalleistung.

Um den Austausch des Reaktionsgases mit frischem Gas zu verbessern, werden in einer bevorzugten Ausführungsform die Mikrowellengeneratoren periodisch während einer Zeitdauer $t_p$ betrieben und während einer Zeitdauer $t_d$ abgeschaltet. Die Zeitdauer $t_d$ liegt vorzugsweise bei zwischen 0,5 und 2 ms und die Zeitdauer $t_p$ zwischen 1 und 100 ms.

3

Gemäß einer zweiten Ausführungsform werden gleichartige, kohärente Mikrowellengeneratoren verwendet, die abwechselnd gepulst betrieben werden. Die Wellenlängen $\lambda_{h1}$ und $\lambda_{h2}$ sind in diesem Fall gleich. Während der Zeitdauer $t_d$ werden die Mikrowellengeneratoren abwechselnd gepulst betrieben, wobei die Taktzeit $t_A$ der Pulse klein ist gegenüber der charakteristischen Reaktions-, Abscheide- und Gaswechselzeiten im Plasma. Die Taktzeiten $t_A$ liegen vorzugsweise im Bereich zwischen einer Mikrosekunde und einhundert Mikrosekunden. In diesem Fall wird die für die Beschichtung oder Plasmabehandlung allein relevante mittlere Leistung unabhängig von der Koordinate x.

Durch die vom Koppelschlitz abgestrahlten Mikrowellenfelder wird ein in einer Dimension (x-Richtung) homogenes Plasma angeregt.

Als Mikrowellenfrequenzen werden Frequenzen im Bereich 400 MHz bis 10 GHz verwendet.

Um großflächige Substrate behandeln oder beschichten zu können, wird das Stubstrat senkrecht zum Koppelschlitz oder der Koppelschlitz bezüglich des Substrates bewegt.

Je nach Material des Substrates und der auf dem Substrat aufzubringenden Schicht ist es von Vorteil, das Substrat zu heizen. Für andere Materialkombinationen kann es wiederum vorteilhaft sein, während des Behandlungs- oder Beschichtungsvorganges das Substrat entsprechend zu kühlen.

Die Vorrichtung zur Durchführung des Verfahrens weist einen Reaktionsraum zur Aufnahme des zu behandelnden oder zu beschichtenden Substrates auf. Im Reaktionsraum mündet ein Gaseinlaß für die Zuführung von Reaktionsgas. Dem Reaktionsraum benachbart ist ein Hohlleiter angeordnet, der einen rechteckigen, vorzugsweise quadratischen Querschnitt aufweist. Der Hohlleiter ist an seinen beiden Enden durch jeweils eine Wand (1. Abschlußwand und 2. Abschlußwand) abgeschlossen.

Im Hohlleiter sind im Abstand $l_1 = \lambda_h/2(n+1/2)$ zwei gekreuzte Mikrowellenpolarisatoren angeordnet.

Die Zuleitungen zur Einspeisung der Mikrowellen sind zwischen der jeweiligen Abschlußwand und dem der Abschlußwand zugeordneten Polarisator angeordnet. Da vorzugsweise eine $H_{10}$ Mode und eine $H_{01}$ Mode eingespeist werden, sind auch die Zuleitungen an den Seitenwänden des Hohlleiters um 90° zueinander versetzt angeordnet.

Der der jeweiligen Zuleitung benachbarte Polarisator ist für die über diese Zuleitung eingespeisten Mikrowellen durchlässig und der von der jeweiligen Zuleitung entfernt angeordnete Polarisator ist für die jeweils eingespeisten Mikrowellen undurchlässig. Auf diese Weise wird erreicht, daß für die beiden eingespeisten Wellen zwischen der jeweiligen Abschlußwand und dem jeweils weiter entfernten Polarisator der Hohlleiter einen Hohlraumresonator bildet, in dem sich stehende Wellen ausbilden, wenn der Abstand der jeweiligen Abschlußwand und des jeweils weiter entfernten Polarisators ein Vielfaches der halben Hohlraumwellenlänge $\lambda_{h1}$ bzw. $\lambda_{h2}$ ist.

Damit die beiden stehenden Wellen um $\lambda_h/4$ gegeneinander verschoben sind, wird der Abstand zwischen der Abschlußwand und dem der Abschlußwand benachbarten Polarisator auf $\lambda_h/4$ oder ein ungeradzahliges Vielfaches von $\lambda_h/4$ eingestellt.

Zwischen den beiden Mikrowellenpolarisatoren ist in einer Längskante des Hohlleiters der Koppelschlitz der Länge s und der Breite $b_1$ eingebracht, der gegen den Reaktionsraum mittels eines aus Mikrowellen durchlässigen Materials bestehenden Fensters abgeschlossen ist.

Die vollständige räumliche Trennung zwischen Hohlleiter und Reaktionsraum bietet den Vorteil, daß die Schichtmaterialien nicht an unerwünschten Stellen abgeschieden werden können. Das Innere des Hohlleiters befindet sich unter einem Druck von vorzugsweise 1 bar, um das Zünden eines unerwünschten Plasmas im Hohlleiter zu vermeiden.

Um mit unterschiedlichen Wellenlängen arbeiten zu können, ohne jeweils einen speziell angepaßten Hohlleiter verwenden zu müssen, sind die Polarisatoren und/oder die Abschlußwände in axialer Richtung verschiebbar angeordnet. Die Verschiebbarkeit der Wände und/oder Polarisatoren erlaubt die Anpassung des Hohlleiters an die Wellenlängen der jeweils eingespeisten Mikrowellen.

Der Grad der Ankopplung an das Plasma kann gemäß einer bevorzugten Ausführungsform dadurch variiert werden, daß der Koppelschlitz in Gestalt eines Koppelkanals ausgebildet ist, der eine Länge d aufweist. Dieser Koppelkanal wird dadurch gebildet, daß am Rand des Koppelschlitzes sich im wesentlichen radial nach außen erstreckende Begrenzungswände angeordnet sind. Die Länge d steht in engem Zusammenhang mit der jeweiligen Wellenlänge $\lambda_h$ der Mikrowellen. Wenn $d = \lambda_h/4$ gewählt wird, ist die Ankopplung schwach mit der Folge, daß auch eine schwache Dämpfung längs des Hohlleiters gegeben ist. Schwache Dämpfung bedeutet, daß der Leistungsabfall in axialer Richtung des Hohlleiters nur gering ausfällt, so daß längs des Koppelschlitzes eine gute Homogenität des Plasmas erreicht werden kann. Wenn $d = 0$ gewählt wird, was gleichbedeutend ist mit dem Weglassen der Begrenzungswände, erhält man eine starke Ankopplung und damit auch eine starke Dämpfung. Die Homogenität des Streifenplasmas wird dadurch verschlechtert. Angestrebt wird vorzugsweise eine möglichst geringe Dämpfung, dies bedeutet, daß d vozugsweise auf $\lambda_h/4$ eingestellt wird. Zwar ist die Ankopplung gering, aber der Leistungseintrag in

4

das Plasma ist mit einer starken Kopplung vergleichbar, weil die Güte des Resonators in diesem Fall ansteigt. Die Mikrowellen laufen im Hohlleiter mehrmals hin und her, so daß der von den Mikrowellen abgegebene Leistungsbeitrag damit ebenso groß ist, wie der einer stark angekoppelten Mikrowelle, die dafür aber aufgrund der Dämpfung nur wenige Male den Hohlleiter durchläuft.

Der Hohlleiter ruht auf einem metallischen Antennenfuß, wobei der Koppelschlitz dem Antennenfuß zugewandt ist. Der Antennenfuß besteht im wesentlichen aus einer Metallplatte, in der ein Schlitz eingebracht ist, dessen Breite der Breite des Koppelschlitzes entspricht. Die Begrenzungswände des Koppelkanals sind nach dem Einsetzen des Hohlleiters leitend mit dem Antennenfuß verbunden. Dies bietet den Vorteil, daß sich die unterbrochenen Wandströme im Bereich des Koppelschlitzes im Antennenfuß fortpflanzen können.

Das Mikrowellenfenster, das den Koppelschlitz bzw. den Koppelkanal verschließt, ist im Antennenfuß eingebettet und liegt vorzugsweise auf Dichtelementen auf, so daß der Innenraum des Hohlleiters gegenüber dem Reaktionsraum vollkommen abgedichtet ist. Dies ist deswegen erforderlich, weil der Druck im Hohlleiter vorzugsweise 1000 mbar beträgt, während der Druck im Reaktionsraum bei etwa 1 mbar liegt.

Die Breite $b_2$ des Antennenfußes beträgt vorzugsweise ein Vielfaches der Breite $b_1$ des Koppelschlitzes. Durch die Wahl der Breite des Antennenfußes wird die Erstreckung der Plasmazone senkrecht zur Längsachse des Hohlleiters festgelegt.

Der Gaseinlaß, durch den alle Komponenten des Reaktionsgases eingeleitet werden, befindet sich seitlich am Antennenfuß und endet vorzugsweise vor dem Mikrowellenfenster im Reaktionsraum. Die Mündung des Gaseinlaßes ist vorzugsweise auf die Breite des Antennenfußes abgestellt, so daß das Reaktionsgas genau in den Bereich eingeleitet wird, in dem das Plasma angeregt wird. Der Gaseinlaß erstreckt sich im wesentlichen über die gesamte Länge des Koppelschlitzes. Auf der gegenüberliegenden Seite des Gaseinlaßes befindet sich der Gasauslaß, der sich ebenfalls über nahezu die gesamte Länge des Koppelschlitzes erstreckt. An den Gasauslaß sind Absaugeinrichtungen angeschlossen, so daß ständig neues Reaktionsgas zugeführt werden kann und eine kontinuierliche Beschichtung durchführbar ist.

Um großflächige Substrate beschichten zu können, ist entweder das Substrat beweglich angeordnet oder aber der Hohlleiter mit Antennenfuß und Gaseinlaß- und Gasauslaßeinrichtungen sind beweglich angeordnet. Mit der Vorrichtung können beispielsweise auch Rohre an ihrer Innenseite beschichtet werden, da die Mikrowelleneinrichtung so kompakt ist, daß diese vollständig in das Rohrinnere eingeführt werden kann. Die Beschichtung erfolgt dann in der Weise, daß entweder das zu beschichtende Rohr rotiert oder aber daß das Rohr festgehalten wird und die Mikrowelleneinrichtung rotiert. In beiden Fällen wird das Plasma über die Innenseite des zu beschichtenden Rohres geführt.

Die Vorrichtung ist auch zur Beschichtung schwach gewölbter Substrate geeignet. Hierzu ist der Hohlleiter ebenfalls in axialer Richtung gekrümmt ausgebildet. Zum Beschichten von zweidimensional gewölbten Substraten wird ein in axialer Richtung gekrümmter Hohlleiter eingesetzt, der auf einer der Substratwölbung angepaßten gekrümmten Bahn relativ zum Substrat bewegbar angeordnet ist.

Vorzugsweise ist auf der dem Hohlleiter abgewandten Seite des Substrates eine Gegenplatte angeordnet. Diese Gegenplatte hat die Aufgabe, das zur Anregung verwendete Mikrowellenfeld räumlich zu konzentrieren. Darüber hinaus kann die Gegenplatte beheizbar ausgebildet sein, so daß die Beschichtung auch unter erhöhten Temperaturen durchgeführt werden kann.

Um die beiden Verfahrensvarianten durchführen zu können, sind die Zuleitungen entweder an zwei Mikrowellengeneratoren angeschlossen, die Mikrowellen der gleichen Wellenlänge oder aber Mikrowellen unterschiedlicher Wellenlänge einspeisen. Wenn identische Mikrowellengereatoren eingesetzt werden, die Mikrowellen gleicher Wellenlänge erzeugen, so werden die Mikowellengeneratoren während der Zeitdauer $t_p$ durch eine geeignete Zusatzeinrichtung abwechselnd gepulst, wobei die Taktzeit $t_A$ im Bereich von einer Mikrosekunde bis 100 Mikrosekunden liegt.

Beispielhafte Ausführungsformen der Erfindung werden nachfolgend anhand der Zeichnungen näher erläutert.

Es zeigen

Figur 1:    eine perspektivische Darstellung des Hohlleiters

Figur 2:    einen Schnitt längs der Linie II-II durch den in Figur 1 gezeigten Hohlleiter mit Antennenfuß und Reaktionsraum

Figur 3:    eine Detaildarstellung des in Figur 2 gezeigten Schnittbildes

Figur 4:    eine perspektivische Darstellung des Hohlleiters mit Antennenfuß zur Verdeutlichung der Wandströme

Figur 5:    eine graphische Darstellung des elektrischen Feldes in Abhängigkeit der Ortskoordinate X

Figur 6:    eine graphische Darstellung des Leistungseintrages in Abhängigkeit von der Ortskoordinate X

Figur 7: zwei graphische Darstellungen A und B der in den Hohlleiter eingekoppelten, gepulsten Leistungen in Abhängigkeit von der Zeit

Figur 8: die schematische Darstellung der Vorrichtung zur Innenbeschichtung von Glasrohren.

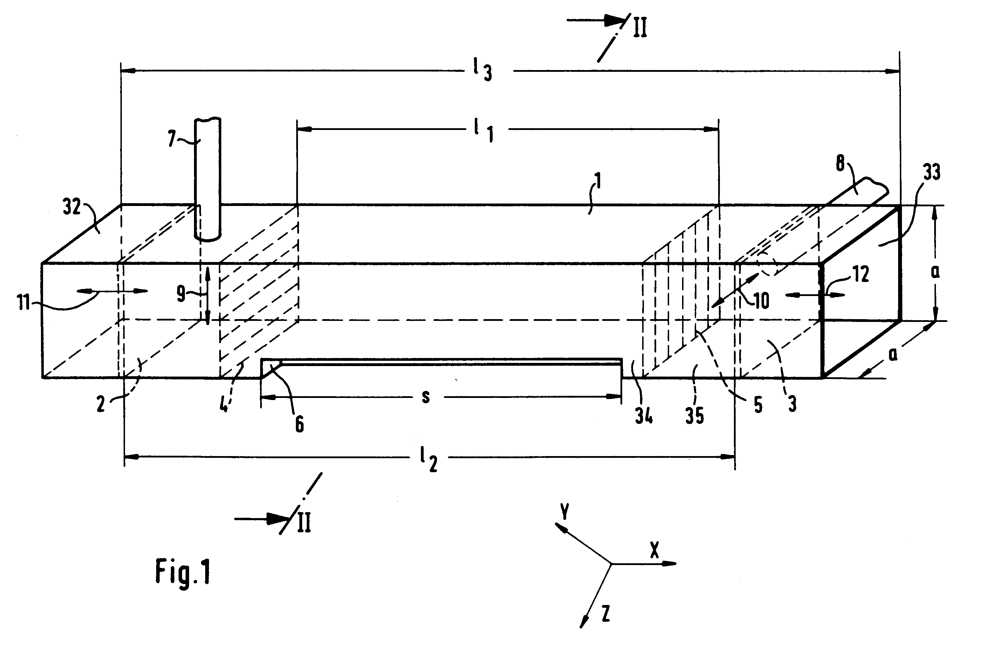

In der Figur 1 ist der Hohlleiter 1 perspektivisch dargestellt. Der Querschnitt des Hohlleiters ist in der hier gezeigten Ausführungsform quadratisch mit der Kantenlänge a. Die Gesamtlänge des Hohlleiters ist durch $l_3$ gekennzeichnet.

An den Endabschnitten des Hohlleiters 1 sind Mirkowellenzuleitungen 7 und 8 vorgesehen, die an Mikrowellengeneratoren angeschlossen sind. Im hier gezeigten Beispiel mündet die Mikrowellenzuleitung 7 an der Seitenwand 32 des Hohlleiters 1. Durch die Mikrowellenzuleitung 7 werden $H_{10}$ Moden in den Hohlleiter 1 eingespeist. Der Doppelpfeil 9 gibt die E-Feldrichtung des $H_{10}$ Modes an.

Die Zuleitung 8 ist an der Seitenwand 33 des Hohlleiters 1 angeschlossen. Durch die Zuleitung 8 werden $H_{01}$ Moden in den Hohlleiter 1 eingespeist. Der Doppelpfeil 10 gibt die E-Feldrichtung des $H_{01}$ Modes an.

Nach außen sind die Enden des Hohlleiters durch eine erste Abschlußwand 2 und durch eine zweite Abschlußwand 3 abgeschlossen. Diese beiden Abschlußwände 2 und 3 sind in axialer Richtung verschiebbar angeordnet. Dies wird durch die Pfeile 11 und 12 verdeutlicht.

Im Innenraum des Hohlleiters 1 sind zwei Mikrowellenpolarisatoren 4 und 5 angeordnet. Der erste Mikrowellenpolarisator 4 ist für die durch die Zuleitung 7 eingespeisten vertikal polarisierten Mikrowellen durchlässig.

Der zweite Mikrowellenpolarisator 5 ist benachbart zur Zuleitung 8 angeordnet und für die durch die Zuleitung 8 eingespeisten horizontal polarisierten Mikrowellen durchlässig. Der Abstand der beiden Mikrowellenpolarisatoren 4 und 5 beträgt $l_1 = \lambda_h/2(n + 1/2)$, wobei n eine ganze Zahl > 0 ist.

Der Polarisator 4 ist für die $H_{01}$ Moden, die durch die Zuleitung 8 eingespeist werden, undurchlässig. Dementsprechend ist der Polarisator 5 für die durch die Zuleitung 7 eingespeisten $H_{10}$ Moden undurchlässig. Der Abstand der ersten Abschlußwand 2 zum zweiten Polarisator 5 ist so gewählt, daß sich zwischen der Abschlußwand 2 und dem Polarisator 5 für die $H_{10}$ Moden stehende Wellen ausbilden. Ebenso ist der Abstand zwischen der zweiten Abschlußwand 3 und dem ersten Polarisator 4 so gewählt, daß sich für die $H_{01}$ Moden ebenfalls stehende Wellen ausbilden. Damit eine Verschiebung der beiden Wellen um $\lambda_h/4$ gewährleistet wird, beträgt der Abstand zwischen der ersten Abschlußwand 2 und dem ersten Polarisator 4 bzw. der zweiten Abschlußwand 3 und dem zweiten Polarisator 5 ein ungeradzahliges Vielfaches der Wellenlänge von $\lambda_h/4$.

Zwischen den beiden Polarisatoren 4 und 5 ist in der vorderen Kante des Hohlleiters 1 ein Koppelschlitz 6 eingebracht, der die Länge s aufweist. Vorzugsweise ist der Koppelschlitz 6 etwas kürzer als der Abstand zwischen den beiden Mikrowellenpolarisatoren 4 und 5.

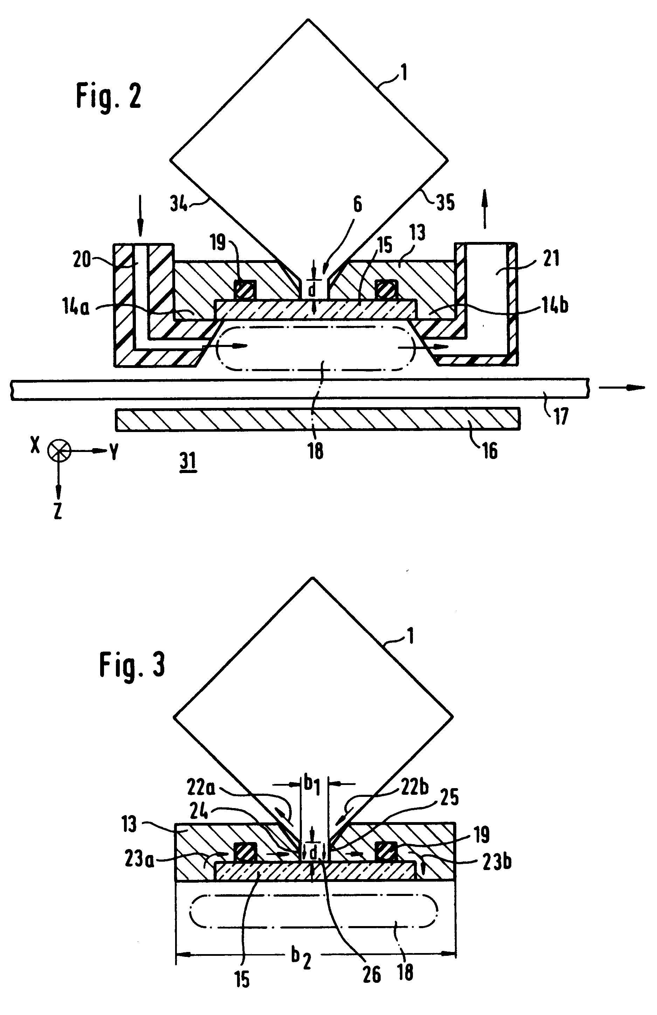

In der Figur 2 ist ein Schnitt durch den Hohlleiter 1 längs der Linie II-II der in Figur 1 gezeigten Darstellung zu sehen. Zusätzlich ist der Antennenfuß 13 dargestellt, auf dem der Hohlleiter 1 ruht. Dadurch, daß der Koppelschlitz 6 in einer der Kanten des Hohlleiters 1 eingebracht ist, ruht der Hohlleiter mit seinen Seitenwänden 34 und 35 auf dem Antennenfuß 13, der aus elektrisch leitendem Material, vorzugsweise Metall besteht. Der Antennenfuß 13 besitzt die Gestalt einer Platte, in der in der Mitte ein Längsschlitz eingebracht ist, dessen Breite im wesentlichen der Breite $b_1$ (siehe Figur 3) entspricht.

Wie in den Figuren 2 und 3 zu sehen ist, sind am Hohlleiter 1 sich nach außen erstreckende Begrenzungswände 24 und 25 im Bereich des Koppelschlitzes 6 angeformt, wodurch ein Koppelkanal 26 der Länge d ausgebildet wird. Die Breite $b_1$ des Koppelschlitzes 6 ist so gewählt, daß es einerseits keine Überschläge zwischen den Begrenzungswänden 24 und 25 gibt und daß andererseits die Wellen in axialer Richtung nicht gestört werden.

Der Koppelschlitz 6 bzw. der Koppelkanal 26 wird gegenüber dem darunter befindlichen Reaktionsraum 31 durch ein Mikrowellenfenster 15 abgeschlossen. Da die Begrenzungswände 24,25 leckdicht mit dem Antennenfuß 13 verbunden sind, und der Innenraum des Hohlleiters 1 ebenfalls vakuumdicht gegenüber dem Reaktionsraum 31 abgeschlossen sein muß, liegt das Mikrowellenfenster 15 auf Dichtungen 19 auf, die im Antennenfuß 13 angeordnet sind. Das Mikrowellenfenster 15 ist im Antennenfuß 13 derart eingebettet, daß die Seitenabschnitte 14a und 14b des Antennenfußes das Mikrowellenfenster 15 übergreifen.

Unterhalb des Mikrowellenfensters 15 ist die Plasmazone 18 schematisch dargestellt. In die Plasmazone wird durch den Gaseinlaß 20 das Reaktionsgas zugeführt. Der Gaseinlaß 20 ist seitlich des Antennenfußes 13 angeordnet und erstreckt sich im wesentlichen über die gleiche Länge wie der Koppelschlitz 6. Auf der gegenüber liegenden Seite des Gaseinlaßes ist seitlich am Antennenfuß 13 der Gasauslaß 21 angeordnet. Auch der Gasauslaß 21 ist schlitzförmig ausgebildet und erstreckt sich über die gesamte Länge des Koppelschlitzes 6. Der Gaseinlaß mündet in der hier gezeigten Stellung kurz vor dem Mikrowellenfenster 15.

Das Substrat 17 wird in y-Richtung unter dem Koppelschlitz 6 verschoben, so daß die Plasmazone 18 über die zu beschichtende Oberfläche des Substrates 17 geführt wird. Da die Plasmazone 18 in x-Richtung homogen ist, und das Substrat 17 kontinuierlich in y-Richtung verschoben wird, wird eine in beiden Dimensionen homogene Beschichtung auf dem Substrat 17 aufgebracht.

Unterhalb des Substrates 17 ist noch eine Gegenplatte 16 vorgesehen, die gegebenenfalls beheizbar ausgebildet ist. Die Gegenplatte 16 ist ebenfalls elektrisch leitend.

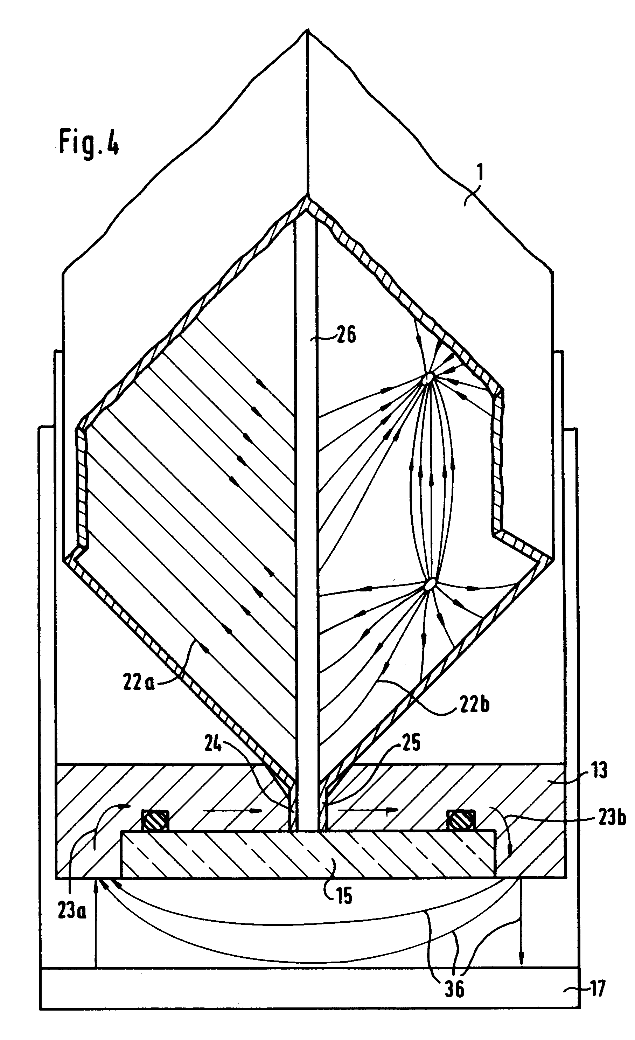

In der Figur 3 ist die in Figur 2 gezeigte Vorrichtung im Detail dargestellt. Die Pfeile 22a und 22b kennzeichnen die Wandströme im Hohlleiter 1. Diese sind in der Figur 4 noch einmal deutlicher dargestellt. Die Wandströme 22a und 22b pflanzen sich im metallischen Antennenfuß 13 aufgrund der leitenden Verbindung mit den Begrenzungswänden 24 und 25 fort und bilden die Ströme 23a und 23b. Diese Ströme führen um das Mikrowellenfenster 15 herum. Aus den Seitenteilen 14a und 14b treten elektrische Feldlinien aus und in die Plasmazone 18 ein.

Wie in der Figur 4 zu sehen ist, bilden sich in der Plasmazone 18 durch das Vorsehen der Gegenplatte 16 das durch die Pfeile 36 gekennzeichnete eingekoppelte Mikrowellenfeld aus.

Die Breite der Plasmazone 18 wird somit im wesentlichen durch die Breite $b_2$ des Antennenfußes 13 festgelegt.

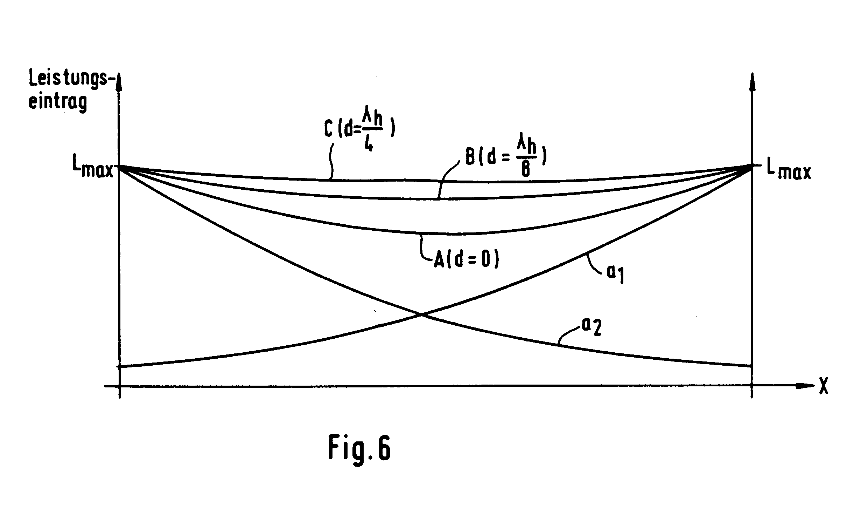

Die Länge d des Koppelkanals 26 wird so gewählt, daß bei guter Ankopplung an das Plasma in axialer Richtung eine weitgehende Homogenität erzielt wird. In der Figur 6 ist der Leistungseintrag längs der Ortskoordinate X dargestellt. Die Kurve a2 beschreibt den Leistungseintrag der durch die Mikrowellenzuleitung 7 eingespeiste $H_{10}$ Mode. Die Kurve a1 verdeutlicht den Leistungseintrag der durch die Mikrowellenzuleitung 8 eingespeiste $H_{01}$ Mode. Durch die Überlagerung der beiden Kurven a1 und a2 ergibt sich eine Art Kettenlinie, die durch die Kurve A dargestellt ist. Der Verlauf der Kurven A, B und C hängt stark von dem Parameter d ab, wobei mit zunehmendem d der Abfall des Leistungseintrages geringer wird. Aus diesem Grunde wird d > 0 gewählt und vorzugsweise auf Werte zwischen $\lambda_h/8$ und $\lambda_h/4$ eingestellt.

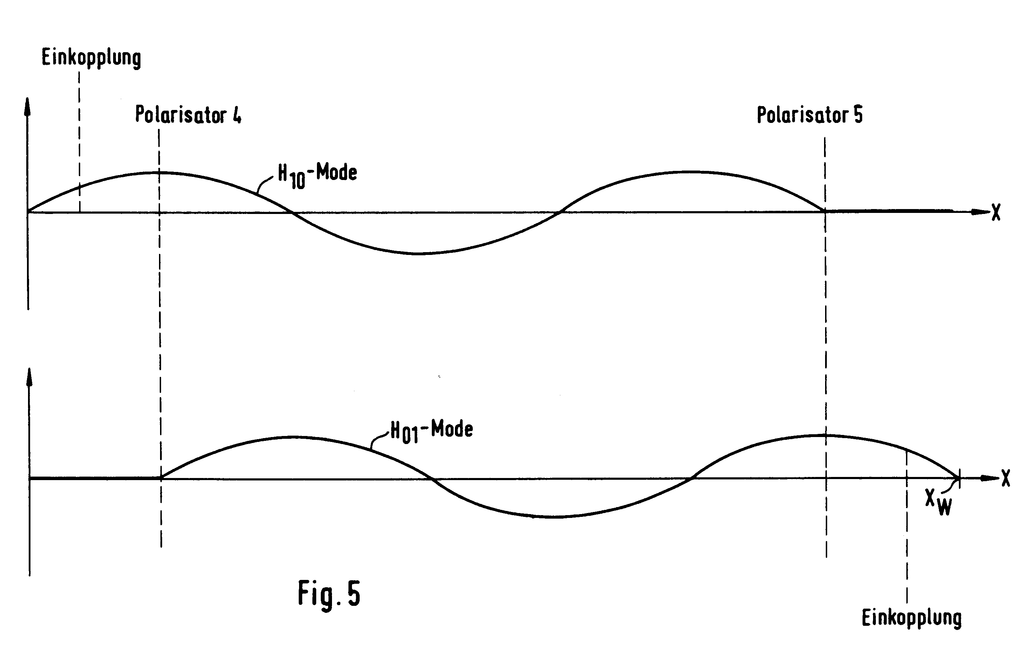

In der Figur 5 sind die beiden stehenden Wellen der $H_{10}$ Mode und der $H_{01}$ Mode in Abhängigkeit von der Ortskoordinate X dargestellt. In der oberen Kurve befindet sich am Ort X = 0 die Abschlußwand 2 und in der unteren Kurve befindet sich am Ort $X_W$ die Abschlußwand 3. Die Position der Polarisatoren 4 und 5 ist durch die punktierten Linien dargestellt. Es ist zu sehen, daß in der oberen Darstellung sich eine stehende Welle zwischen der Wand 2 und dem Polarisator 5 ausbildet, während in der unteren Darstellung die stehende Welle zwischen Polarisator 4 und Wand 3 erzeugt wird. Beide Wellen sind um eine viertel Wellenlänge gegeneinander verschoben.

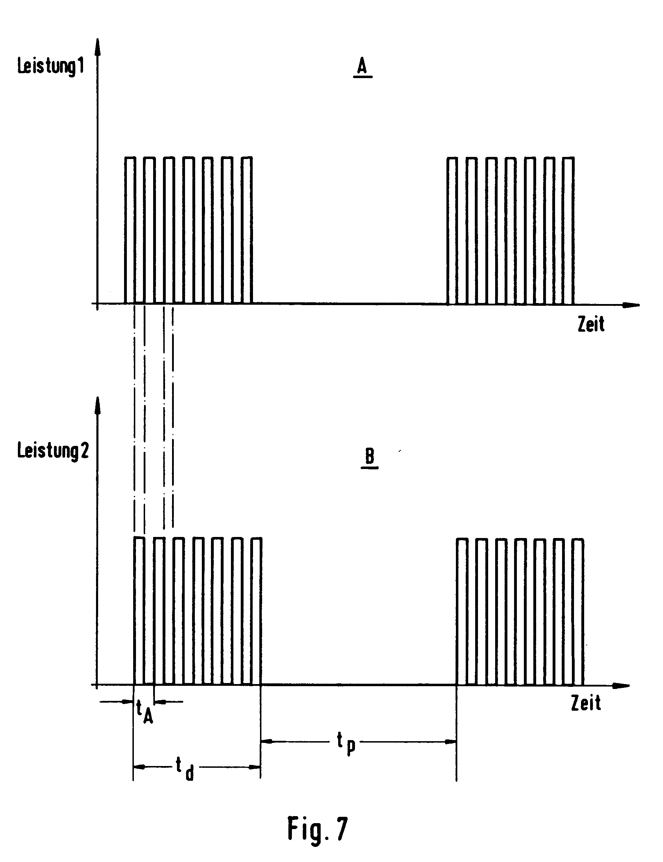

Gemäß einer Ausführungsform können durch die Mikrowellenzuleitungen 7 und 8 Mikrowellen gleicher Wellenlänge eingespeist werden. Bei dieser Ausführungsform werden die Mikrowellen gepulst, und zwar mit einer Taktzeit $t_A$. Die in der Figur 7 gezeigte obere Darstellung zeigt die durch die Mikrowellenzuführung 7 eingespeiste Leistung 1 und die in der unteren Darstellung gezeigte Kurve zeigt die durch die Mikrowellenzuleitung 8 eingespeiste Leistung $L_2$. Die Taktzeiten $t_A$ sind in beiden Fällen gleich, wobei die Einspeisung durch die Mikrowellenzuleitung 8 immer dann erfolgt, wenn keine Einspeisung durch die Zuleitung 7 erfolgt und umgekehrt. Um den Gasaustausch im Reaktionsvolumen zu verbessern, werden die Mikrowellengeneratoren periodisch während der Zeit $t_d$ eingeschaltet und während der Zeitdauer $t_p$ ausgeschaltet. Während der Ausschaltzeit $t_p$ kann frisches Reaktionsgas das vorhandene Gas aus dem Reaktionsraum verdrängen.

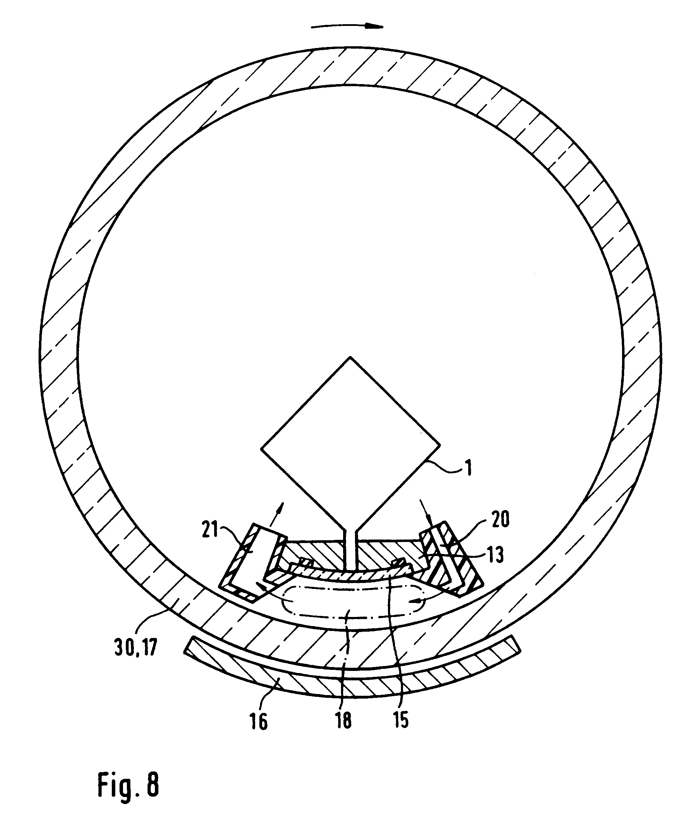

In der Figur 8 ist eine weitere Ausführungsform dargestellt, mit der ein Substrat 17 in Gestalt eines Glasrohres 30 innen beschichtet wird. Vorzugsweise ist der Antennenfuß 13 und das Mikrowellenfenster 15 an den Krümmungsradius des Glasrohres angepaßt. Für die Ausführung der Beschichtung gibt es zwei Möglichkeiten. Zum einen kann der Hohlleiter 1 ortsfest angeordnet sein und das Glasrohr 30 rotiert um den Hohlleiter 1. Es ist aber auch möglich, das Glasrohr 30 ortsfest anzuordnen und den Hohlleiter 1 im Rohr 30 rotieren zu lassen.

In den nachfolgenden Tabellen 1 und 2 sind Ausführungsbeispiele für die Bemaßung des Hohlleiters bzw. die Prozessparameter für eine $TiO_2$-Beschichtung zusammengestellt.

# EP 0 511 492 B1

Tabelle 1

| Ausführungsbeispiel für die Bemaßung des Hohlleiters für 2.45 GHz Mikrowellenfrequenz: | |
| --- | --- |
| Größe | Wert |
| a | 73 mm |
| s | 580 mm |
| $l_1$ | 605 mm |
| $l_2$ | 715 mm |
| $l_3$ | 825 mm |
| $\lambda_h$ | 220 mm |
| Breite Antennenfuß $b_2$ | 50 mm |

Tabelle 2

| Ausführungsbeispiel Prozessparameter für eine TiO2-Beschichtung: | |
| --- | --- |
| Größe | Wert |
| Frequenz | 2,45 GHz |
| Pulsleistung | 2 x 6,0 kW |
| Pulsdauer | 1 ms |
| Pulspause | 9 ms |
| Taktzeit $t_A$ | 0,1 ms |
| mittl. Leistung | 1,2 kW |
| Massenfluß 02 | 1,5 slm |
| Massenfluß TiC14 | 15 sccm |
| Prozeßdruck | 1 mbar |
| Vorschub Substrat | 10 cm/min |

BEZUGSZEICHENLISTE

1. Hohlleiter
2. erste Abschlußwand
3. zweite Abschlußwand
4. erster Polarisator
5. zweiter Polarisator
6. Koppelschlitz
7. Zuleitung für Mikrowellen
8. Zuleitung für Mikrowellen
9. E-Feldrichtung des $H_{10}$ Modus
10. E-Feldrichtung des $H_{01}$ Modus
11. Verschieberichtung
12. Verschieberichtung
13. Antennenfuß
14.a,b seitliche Vorsprünge des Antennenfußes
15. Mikrowellenfenster
16. Gegenplatte
17. Substrat
18. Plasmazone
19. Dichtung
20. Gaseinlaß
21. Gasauslaß
22.a,b Wandströme

8

| | |
|---|---|
| 23.a,b | Wandströme |
| 24. | Begrenzungswand |
| 25. | Begrenzungswand |
| 26. | Koppelkanal |
| 27. | - |
| 28. | - |
| 29. | Bewegungsbahn |
| 30. | Glasrohr |
| 31. | Reaktionsraum |
| 32. | Seitenwand |
| 33. | Seitenwand |
| 34. | Seitenwand |
| 35. | Seitenwand |
| 36. | Pfeilrichtung |

**Patentansprüche**

1. Verfahren zur Behandlung oder Beschichtung von Substraten, bei dem ein zur Abscheidung befähigtes Reaktionsgas auf die zu beschichtende Fläche strömt und das Reaktionsgas mittels in einem Hohlleiter erzeugter Mikrowellen zu einem streifenförmigen Plasma angeregt wird, dadurch gekennzeichnet, daß ein im Querschnitt quadratischer Hohlleiter verwendet wird, in dem zwei senkrecht zueinander polarisierte, stehende Wellen der Wellenlänge $\lambda_{h1}$, $\lambda_{h2}$ angeregt werden, die um eine viertel Wellenlänge relativ zueinander verschoben sind, und daß die Ankopplung der Mikrowellen an das Plasma über einen in einer der Kanten des Hohlleiters eingebrachten Längsschlitz erfolgt.

2. Verfahren nach Anspruch 1, dadurch gekennzeichnet, daß zwei Wellen mit unterschiedlicher Wellenlänge $\lambda_{h1}$, $\lambda_{h2}$ erzeugt werden.

3. Verfahren nach Anspruch 2, dadurch gekennzeichnet, daß sich die Wellenlänge $\lambda_{h1}$, $\lambda_{h2}$ um weniger als 1% voneinander unterscheiden.

4. Verfahren nach einem der Ansprüche 1 bis 3, dadurch gekennzeichnet, daß die Mikrowellen mittels zweier Mikrowellengeneratoren erzeugt werden, wobei die Mikrowellengeneratoren zur Verbesserung des Gasaustausches periodisch während der Zeitdauer $t_d$ ein- und während der Zeitdauer $t_p$ ausgeschaltet werden.

5. Verfahren nach Anspruch 4, dadurch gekennzeichnet, daß die Mikrowellengeneratoren zwei Wellen gleicher Wellenlänge $\lambda_{h1}$ = $\lambda_{h2}$ = $\lambda_h$ erzeugen und während der Zeitdauer $t_d$ abwechselnd gepulst betrieben werden, wobei die Taktzeit $t_A$ der Pulse klein gegen die charakteristischen Reaktions-, Abscheide- und Gaswechselzeiten im Plasma gehalten werden.

6. Verfahren nach einem der Ansprüche 4 oder 5, dadurch gekennzeichnet, daß die Einschaltzeit $t_d$ zwischen 0,5 und 2 ms und die Ausschaltzeit $t_p$ zwischen 1 und 100 ms gewählt werden.

7. Verfahren nach einem der Ansprüche 4 oder 6, dadurch gekennzeichnet, daß die Taktzeit $t_A$ zwischen 1 μsec und 100 μsec gewählt wird.

8. Verfahren nach einem der Ansprüche 1 bis 7, dadurch gekennzeichnet, daß die Mikrowelleneinspeisung an den Enden des Hohlleiters vorgenommen wird.

9. Verfahren nach einem der Ansprüche 1 bis 8, dadurch gekennzeichnet, daß Mikrowellenfrequenzen zwischen 400 MHz und 10 GHz verwendet werden.

10. Verfahren nach einem der Ansprüche 1 bis 9, dadurch gekennzeichnet, daß das Substrat während der Beschichtung oder Behandlung senkrecht zum Längsschlitz bewegt oder der Längsschlitz bezüglich des Substrates bewegt wird.

EP 0 511 492 B1

**11.** Verfahren nach einem der Ansprüche 1 bis 10, dadurch gekennzeichnet, daß das Substrat geheizt wird.

**12.** Verfahren nach einem der Ansprüche 1 bis 10, dadurch gekennzeichnet, daß das Substrat während der Behandlung oder der Beschichtung gekühlt wird.

**13.** Vorrichtung zur Durchführung des Verfahrens nach Anspruch 1 mit einem Reaktionsraum zur Aufnahme des zu behandelnden oder zu beschichtenden Substrates, mit einem Gaseinlaß für die Zuführung von Reaktionsgas in den Reaktionsraum und mit einem dem Reaktionsraum benachbarten Hohlleiter, in dem Mikrowellen der Wellenlänge $\lambda_{h1},\lambda_{h2}$ angeregt sind, dadurch gekennzeichnet,

daß der Hohlleiter (1) an seinen beiden Enden durch jeweils eine Wand (erste Abschlußwand (2) und zweiter Abschlußwand (3) ) abgeschlossen ist,

daß im Hohlleiter (1) im Abstand $l_1 = \lambda_{h2}/2$ (n + 1/2) zwei gekreuzte Mikrowellenpolarisatoren (erster Polarisator (4) und zweiter Polarisator (5) ) angeordnet sind,

daß zwischen der Abschlußwand (2, 3) und dem jeweils zugeordneten Polarisator (4) bzw. (5), jeweils eine Zuleitung (7, 8) zur Einspeisung der Mikrowellen angeordnet ist, wobei der der jeweiligen Zuleitung (7, 8) benachbarte Polarisator (4, 5) für die eingespeisten Mikrowellen durchlässig und der von der jeweiligen Zuleitung (7, 8) entfernt angeordnete Polarisator (4, 5) für die eingespeisten Mikrowellen undurchlässig ist,

daß der Abstand zwischen Abschlußwand (2, 3) und dem jeweils entfernt angeordneten Polarisator (4, 5) zur Ausbildung von stehenden Wellen gewählt ist, und

daß der Hohlleiter (1) einen quadratischen Querschnitt aufweist, in dessen einer Längskante im Bereich zwischen den Polarisatoren (4, 5) ein Koppelschlitz (6) der Länge s und der Breite $b_1$ eingebracht ist, der gegen den Reaktionsraum mittels eines aus Mikrowellen durchlässigen Materials bestehenden Fensters (15) abgeschlossen ist.

**14.** Vorrichtung nach Anspruch 13, dadurch gekennzeichnet, daß die Abschlußwände (2, 3) und/oder die Polarisatoren (4, 5) in axialer Richtung verschiebbar angeordnet sind.

**15.** Vorrichtung nach einem der Ansprüche 13 bis 14, dadurch gekennzeichnet, daß zur Ausbildung eines Koppelkanals (26) der Länge d am Hohlleiter (1) am Rand des Koppelschlitzes (6) sich im wesentlichen radial nach außen erstreckende Begrenzungswände (24, 25) angeordnet sind.

**16.** Vorrichtung nach einem der Ansprüche 13 bis 15, dadurch gekennzeichnet, daß die Länge d im Bereich $0 \leq d \leq \lambda_h/4$ einstellbar ist.

**17.** Vorrichtung nach einem der Ansprüche 13 bis 17, dadurch gekennzeichnet, daß der Hohlleiter (1) auf einem metallischen Antennenfuß (13) ruht, der leitend mit den Begrenzungswänden (24, 25) verbunden ist.

**18.** Vorrichtung nach einem der Ansprüche 13 bis 17, dadurch gekennzeichnet, daß das Mikrowellenfenster (15) im Antennenfuß (13) eingebettet ist.

**19.** Vorrichtung nach einem der Ansprüche 13 bis 18, dadurch gekennzeichnet, daß die Breite $b_2$ des Antennfußes (13) ein Vielfaches der Breite $b_1$ des Koppelschlitzes (6) beträgt.

**20.** Vorrichtung nach einem der Ansprüche 13 bis 19, dadurch gekennzeichnet, daß der Gaseinlaß (20) seitlich am Antennenfuß (13) angeordnet ist und vor dem Mikrowellenfenster (15) in dem Reaktionsraum (31) mündet.

**21.** Vorrichtung nach einem der Ansprüche 13 bis 20, dadurch gekennzeichnet, daß das Substrat (17) oder der Hohlleiter (1) mit Antennenfuß (13) und Gaseinlaß (20) beweglich angeordnet sind.

**22.** Vorrichtung nach einem der Ansprüche 13 bis 21, dadurch gekennzeichnet, daß auf der dem Hohlleiter (1) abgewandten Seite des Substrates (17) eine Gegenplatte (16) angeordnet ist.

**23.** Vorrichtung nach Anspruch 22, dadurch gekennzeichnet, daß die Gegenplatte (16) beheizbar ist.

10

**24.** Vorrichtung nach einem der Ansprüche 13 bis 23, dadurch gekennzeichnet, daß die beiden Zuleitungen (7, 8) an zwei Mikrowellengeneratoren (27, 28) angeschlossen sind, die periodisch während einer Zeitdauer $t_d$ eingeschaltet und während einer Zeitdauer $t_p$ ausgeschaltet sind und die Mikrowellen der Wellenlänge $\lambda_{h1}$ und $\lambda_{h2}$ erzeugen, wobei $(\lambda_{h1} - \lambda_{h2}) / \lambda_{h1} < 0,01$ ist.

**25.** Vorrichtung nach einem der Ansprüche 13 bis 23, dadurch gekennzeichnet, daß die beiden Zuleitungen (7, 8) an zwei Mikrowellengeneratoren (27, 28) angeschlossen sind, die periodisch während einer Zeitdauer $t_d$ eingeschaltet und während einer Zeitdauer $t_p$ ausgeschaltet sind, die Mikrowellen der gleichen Wellenlänge $\lambda_h$ erzeugen, wobei die Mikrowellengeneratoren während der Zeitdauer $t_d$ Pulssequenzen der Taktzeit $t_A$ mit $1~\mu sec \leq t_A \leq 100~\mu sec$ erzeugen, so daß jeweils der eine Generator Leistung abgibt, wenn der andere ausgeschaltet ist und umgekehrt.

**26.** Vorrichtung nach einem der Ansprüche 13 bis 25, dadurch gekennzeichnet, daß zur Innenbeschichtung eines Rohres (30) der Hohlleiter (1) mit Antennenfuß (13) und Gaseinlaß (20) an der Innenwand eines rotierenden Rohres angeordnet sind.

## Claims

**1.** Method of treating or coating substrates in which a reaction gas capable of being deposited flows onto the surface to be coated and the reaction gas is excited to form a strip-type plasma by means of microwaves generated in a waveguide, characterized
in that a waveguide is used which is square in cross section and in which two mutually perpendicularly polarized standing waves of wavelength $\lambda_{h1}$, $\lambda_{h2}$ are excited, which waves are displaced by a quarter wavelength relative to one another, and
in that the microwaves are coupled to the plasma via a longitudinal slot provided in one of the edges of the waveguide.

**2.** Method according to Claim 1, characterized in that two waves having different wavelengths $\lambda_{h1}$, $\lambda_{h2}$ are generated.

**3.** Method according to Claim 2, characterized in that the wavelengths $\lambda_{h1}$, $\lambda_{h2}$ differ from one another by less than 1%.

**4.** Method according to one of Claims 1 to 3, characterized in that the microwaves are generated by means of two microwave generators, the microwave generators being periodically switched on during the time $t_d$ and off during the time $t_p$ in order to improve the gas exchange.

**5.** Method according to Claim 4, characterized in that the microwave generators generate two waves of the same wavelength $\lambda_{h1} = \lambda_{h2} = \lambda_h$ and are alternately pulse-operated during the time $t_d$, the clock time $t_A$ of the pulses being kept small compared with the characteristic reaction, deposition and gas-exchange times in the plasma.

**6.** Method according to either of Claims 4 or 5, characterized in that the switch-on time $t_d$ is chosen between 0.5 and 2 ms and the switch-off time $t_p$ is chosen between 1 and 100 ms.

**7.** Method according to either of Claims 4 or 6, characterized in that the clock time $t_A$ is chosen between 1 $\mu$sec and 100 $\mu$sec.

**8.** Method according to one of Claims 1 to 7, characterized in that the microwaves are injected at the ends of the waveguide.

**9.** Method according to one of Claims 1 to 8, characterized in that microwave frequencies of between 400 MHz and 10 GHz are used.

**10.** Method according to one of Claims 1 to 9, characterized in that the substrate is moved perpendicularly with respect to the longitudinal slot during the coating or treatment or the longitudinal slot is moved with respect to the substrate.

**11.** Method according to one of Claims 1 to 10, characterized in that the substrate is heated.

**12.** Method according to one of Claims 1 to 10, characterized in that the substrate is cooled during the treating or coating.

**13.** Apparatus for carrying out the method according to Claim 1, having a reaction chamber for receiving the substrate to be treated or to be coated, having a gas inlet for the supply of reaction gas to the reaction chamber, and having a waveguide which is adjacent to the reaction chamber and in which microwaves having a wavelength $\lambda_{h1}$, $\lambda_{h2}$ are excited, characterized
in that the waveguide (1) is terminated at its two ends in each case by a wall (first end wall (2) and second end wall (3)),
in that two crossed microwave polarizers (first polarizer (4) and second polarizer (5)) are disposed in the waveguide (1) at a distance of $l_1 = \lambda_{h2}/2\,(n + 1/2)$,
in that one feed line (7, 8) for injecting the microwaves is disposed in each case between the end wall (2, 3) and the polarizer (4) or (5) allocated in each case, the polarizer (4, 5) adjacent to the respective feed line (7, 8) being transparent to the injected microwaves and the polarizer (4, 5) disposed at a distance from the respective feed line (7, 8) being opaque to the injected microwaves,
in that the distance between end wall (2, 3) and the polarizer (4, 5) disposed at a distance in each case is chosen in order to form standing waves, and
in that the waveguide (1) has a square cross section, in one longitudinal edge of which a coupling slot (6) of length s and of width $b_1$ is provided in the region between the polarizers (4, 5), which coupling slot (6) is sealed off from the reaction chamber by means of a window (15) composed of microwave-transparent material.

**14.** Apparatus according to Claim 13, characterized in that the end walls (2, 3) and/or the polarizers (4, 5) are disposed so as to be displaceable in the axial direction.

**15.** Apparatus according to one of Claims 13 to 14, characterized in that, to form a coupling channel (26) of length d on the waveguide (1), boundary walls (24, 25) which extend essentially radially outwards are disposed at the edge of the coupling slot (6).

**16.** Apparatus according to one of Claims 13 to 15, characterized in that the length d can be adjusted in the range $0 \leq d \leq \lambda_h/4$.

**17.** Apparatus according to one of Claims 13 to 17, characterized in that the waveguide (1) rests on a metallic aerial base (13) which is connected in a conducting manner to the boundary walls (24, 25).

**18.** Apparatus according to one of Claims 13 to 17, characterized in that the microwave window (15) is embedded in the aerial base (13).

**19.** Apparatus according to one of Claims 13 to 18, characterized in that the width $b_2$ of the aerial base (13) is a multiple of the width $b_1$ of the coupling slot (6).

**20.** Apparatus according to one of Claims 13 to 19, characterized in that the gas inlet (20) is disposed laterally on the aerial base (13) and opens into the reaction chamber (31) in front of the microwave window (15).

**21.** Apparatus according to one of Claims 13 to 20, characterized in that the substrate (17) or the waveguide (1) with aerial base (13) and gas inlet (20) are movably disposed.

**22.** Apparatus according to one of Claims 13 to 21, characterized in that a counterplate (16) is disposed on that side of the substrate (17) which is remote from the waveguide (1).

**23.** Apparatus according to Claim 22, characterized in that the counterplate (16) can be heated.

**24.** Apparatus according to one of Claims 13 to 23, characterized in that the two feed lines (7, 8) are connected to two microwave generators (27, 28) which are periodically switched on for a time $t_d$ and switched off for a time $t_p$ and which generate microwaves of the wavelength $\lambda_{h1}$ and $\lambda_{h2}$, $(\lambda_{h1} - \lambda_{h2})/\lambda_{h1}$

being < 0.01.

**25.** Apparatus according to one of Claims 13 to 23, characterized in that the two feed lines (7, 8) are connected to two microwave generators (27, 28) which are periodically switched on for a time $t_d$ and switched off for a time $t_p$ and which generate microwaves of the same wavelength $\lambda_h$, the microwave generators generating pulse sequences of clock time $t_A$ where $1\ \mu sec \leq t_A \leq 100\ \mu sec$ during the time $t_d$ so that, in each case, one generator supplies power if the other generator is switched off, and vice versa.

**26.** Apparatus according to one of Claims 13 to 25, characterized in that, to coat a tube (30) internally, the waveguide (1) with aerial base (13) and gas inlet (20) are disposed at the inside wall of a rotating tube.

## Revendications

**1.** procédé pour le traitement ou le revêtement de substrats dans lequel un gaz réactif apte à former un dépôt balaye la surface à revêtir et le gaz réactif est excité au moyen de microondes produites dans un guide d'ondes aux fins de former un plasma en bande, caractérisé
par le fait que l'on utilise un guide d'ondes à section transversale carrée dans lequel on excite deux ondes stationnaires à polarisation réciproque perpendiculaire de longueur d'onde $\lambda_{h1}$, $\lambda_{h2}$ qui sont mutuellement déphasées du quart de la longueur d'onde et
par le fait que les microondes sont couplées dans le plasma par l'intermédiaire d'une fente longitudinale aménagée dans l'une des arêtes du guide d'ondes.

**2.** Procédé selon la revendication 1, caractérisé par le fait que l'on produit deux ondes de longueur d'onde $\lambda_{h1}$, $\lambda_{h2}$ différente.

**3.** Procédé selon la revendication 2, caractérisé par le fait que les longueurs d'onde $\lambda_{h1}$, $\lambda_{h2}$ diffèrent l'une de l'autre de moins de 1 %.

**4.** Procédé selon l'une des revendications 1 à 3, caractérisé par le fait que les microondes sont produites au moyen de deux générateurs de microondes, les générateurs de microondes étant périodiquement mis en fonctionnement pendant la durée $t_d$ et hors fonctionnement pendant la durée $t_p$ aux fins d'améliorer l'échange gazeux.

**5.** Procédé selon la revendication 4, caractérisé par le fait que les générateurs de microondes produisent deux ondes de même longueur d'onde $\lambda_{h1} = \lambda_{h2} = \lambda_h$ et fonctionnent de manière pulsée en alternance pendant la durée $t_d$, le temps de cycle $t_A$ des impulsions étant maintenu petit par rapport aux temps caractéristiques de réaction, de dépôt et d'échange gazeux dans le plasma.

**6.** Procédé selon l'une des revendications 4 ou 5, caractérisé par le fait que le temps de fonctionnement $t_d$ est compris entre 0,5 et 2 ms et le temps hors fonctionnement entre 1 et 100 ms.

**7.** Procédé selon l'une des revendications 4 ou 6, caractérisé par le fait que le temps de cycle $t_A$ est compris entre $1\ \mu sec$ et $100\ \mu sec$.

**8.** Procédé selon l'une des revendications 1 à 7, caractérisé par le fait que les microondes sont introduites aux extrémités du guide d'ondes.

**9.** Procédé selon l'une des revendications 1 à 8, caractérisé par le fait que l'on utilise des fréquences de microondes comprises entre 400 MHz et 10 GHz.

**10.** Procédé selon l'une des revendications 1 à 9, caractérisé par le fait que pendant le revêtement ou le traitement on déplace le substrat perpendiculairement à la fente longitudinale ou la fente longitudinale par rapport au substrat.

**11.** Procédé selon l'une des revendications 1 à 10, caractérisé par le fait que l'on chauffe le substrat.

**12.** Procédé selon l'une des revendications 1 à 10, caractérisé par le fait que pendant le revêtement ou le traitement on refroidit le substrat.

**13.** Dispositif pour la mise en oeuvre du procédé selon la revendication 1, comportant une chambre de réaction destinée à recevoir le substrat à traiter ou à revêtir, une entrée de gaz pour l'amenée de gaz réactif dans la chambre de réaction et un guide d'ondes qui est disposé au voisinage de la chambre de réaction et dans lequel des microondes de longueur d'onde $\lambda_{h1}$, $\lambda_{h2}$ sont excitées, caractérisé par le fait que le guide d'ondes (1) est fermé à ses deux extrémités par une paroi (première paroi de fermeture (2) et deuxième paroi de fermeture (3)), par le fait que deux polarisateurs croisés de microondes (premier polarisateur (4) et deuxième polarisateur (5)) sont disposés à l'intérieur du guide d'ondes à une distance l'un de l'autre $l_1 = \lambda_{h2} / 2$ (n + 1/2), par le fait qu'un conduit d'entrée (7, 8) pour l'introduction des microondes est disposé entre la paroi de fermeture (2, 3) et le polarisateur (4) ou (5) associé, le polarisateur (4, 5) voisin du conduit d'entrée (7, 8) concerné étant perméable aux microondes introduites et le polarisateur (4, 5) éloigné du conduit d'entrée (7, 8) concerné ne laissant pas passer les microondes introduites, par le fait que la distance entre la paroi de fermeture (2, 3) et le polarisateur (4, 5) éloigné est choisie de manière à former des ondes stationnaires et par le fait que le guide d'ondes (1) présente une section carrée avec, aménagé dans l'une des arêtes longitudinales de celui-ci, dans la zone comprise entre les polarisateurs (4, 5), une fente de couplage (6) de longueur s et de largeur $b_1$ qui est fermée vis-à-vis de la chambre de réaction au moyen d'une fenêtre (15) en un matériau perméable aux microondes.

**14.** Dispositif selon la revendication 13, caractérisé par le fait que les parois de fermeture (2, 3) et/ou les polarisateurs (4, 5) sont disposés avec possibilité de déplacement dans la direction axiale.

**15.** Dispositif selon l'une des revendications 13 à 14, caractérisé par le fait que des parois de limitation (24, 25) qui s'étendent sensiblement radialement vers l'extérieur sont disposées sur le guide d'ondes (1) sur le bord de la fente de couplage (6), aux fins de former un conduit de couplage (26) de longueur d.

**16.** Dispositif selon l'une des revendications 13 à 15, caractérisé par le fait que la longueur d peut être réglée dans la plage $0 \leqq d \leqq \lambda_h / 4$.

**17.** Dispositif selon l'une des revendications 13 à 16, caractérisé par le fait que le guide d'ondes (1) repose sur un pied d'antenne (13) qui relié de manière conductrice aux parois de limitation (24, 25).

**18.** Dispositif selon l'une des revendications 13 à 17, caractérisé par le fait que la fenêtre (15) à microondes est insérée dans le pied d'antenne (13).

**19.** Dispositif selon l'une des revendications 13 à 18, caractérisé par le fait que la largeur $b_2$ du pied d'antenne (13) est égale à un multiple de la largeur $b_1$ de la fente de couplage (6).

**20.** Dispositif selon l'une des revendications 13 à 19, caractérisé par le fait que l'entrée de gaz (20) est disposée sur le côté du pied d'antenne (13) et débouche dans la chambre de réaction (31) devant la fenêtre à microondes (15).

**21.** Dispositif selon l'une des revendications 13 à 20, caractérisé par le fait que le substrat (17) ou le guide d'ondes (1) avec le pied d'antenne (13) et l'entrée de gaz (20) sont mobiles.

**22.** Dispositif selon l'une des revendications 13 à 21, caractérisé par le fait qu'une contre-plaque (16) est disposée sur la face du substrat (17) éloignée du guide d'ondes (1).

**23.** Dispositif selon la revendication 22, caractérisé par le fait que la contre-plaque (16) peut être chauffée.

**24.** Dispositif selon l'une des revendications 13 à 23, caractérisé par le fait que les deux conduits d'entrée (7, 8) sont reliés à deux générateurs de microondes (27, 28) qui sont périodiquement mis en fonctionnement pendant une durée $t_d$ et hors fonctionnement pendant une durée $t_p$ et produisent des microondes de longueur d'onde $\lambda_{h1}$ et $\lambda_{h2}$, $(\lambda_{h1} - \lambda_{h2})/ \lambda_{h1} < 0,01$.

**25.** Dispositif selon l'une des revendications 13 à 23, caractérisé par le fait que les deux conduits d'entrée (7, 8) sont connectés à deux générateurs de microondes (27, 28) qui sont périodiquement mis en fonctionnement pendant une durée $t_d$ et hors fonctionnement pendant une durée $t_p$ et produisent des microondes de même longueur d'onde $\lambda_h$, les générateurs de microondes produisant pendant la durée $t_d$ des séquences d'impulsions avec un temps de cycle $t_A$, 1 $\mu$sec $\leq t_A \leq$ 100 $\mu$sec, de telle sorte que l'un des générateurs délivre une puissance lorsque l'autre générateur est hors fonctionnement et inversement.

**26.** Dispositif selon l'une des revendications 13 à 25, caractérisé par le fait que, aux fins de revêtir intérieurement un tube (30), le guide d'ondes (1) avec le pied d'antenne (13) et l'entrée de gaz (20) sont disposés contre la paroi intérieure d'un tube tournant.

Fig.1

EP 0 511 492 B1

Fig. 2

Fig. 3

Fig.4

Fig. 5

Fig.6

EP 0 511 492 B1

Fig. 7

Fig. 8